# FASCICULE DE BREVET EUROPEEN

(11) **EP 2 020 833 B1**
(45) Date de publication et mention de la délivrance du brevet: **22.09.2010**
(21) Numéro de dépôt: 08290744.5
(22) Date de dépôt: 31.07.2008
(51) Int. Cl.: H05K 3/00

(54) **Procédé de fabrication d'un circuit imprimé semi-flexible, plaque utilisée pour un tel procédé, circuit imprimé et dispositif électronique associés**
Herstellungsverfahren für eine starr-flexible Leiterplatte, Brett das für ein solches Verfahren benutzt wird, und damit verbundenen Leiterplatte und elektrischer Gegenstand
Manufacturing method for a semi-flexible printed circuit, board used for such a process, and related printed circuit and electrical device

(30) Priorité: 31.07.2007 FR 0705604
(43) Date de publication de la demande: 04.02.2009
(73) Titulaire: Beauce Réalisations et Études Électroniques (BREE), 45390 Puiseaux (FR)
(72) Inventeur: Degottex, Jean-Marc, 45340 Beaune la Rolande (FR); Belnoue, Olivier, 45390 Ondreville sur Essonne (FR)
(74) Mandataire: Novagraaf Technologies

(56) Documents cités:
- EP-A- 0 126 856
- EP-A- 0 175 045
- EP-A- 0 195 935
- EP-A- 0 440 928
- EP-B- 0 776 596
- DE-A1- 2 914 336
- DE-A1- 3 417 223
- DE-C1- 4 206 746
- DE-C1- 4 208 610
- GB-A- 2 063 571
- US-A1- 2004 118 595
- US-A1- 2006 231 198
- US-B1- 6 687 984
- US-B1- 7 234 230

## Description

L'invention concerne le domaine des circuits électroniques type imprimés et/ou intégrés, et plus précisément des circuits flex-rigides ou semi-flexibles.

L'invention se rapporte également à un procédé de fabrication d'un circuit flex-rigide, ainsi qu'à une plaque utilisée lors de ce processus de fabrication, à un circuit imprimé et un dispositif électronique associés.

Les circuits imprimés sont principalement constitués d'un support doublé d'une ou plusieurs couches de métal conducteur sur lesquelles sont montés des composants électroniques. Un circuit flex-rigide ou semi-flexible comprend une portion de circuit dont le support est rigide et une autre portion dont le support est flexible.

Le développement des circuits imprimés flexibles (à support flexible) a permis de s'affranchir de l'utilisation de connectiques filaires pour relier deux circuits rigides. Bien qu'initialement utilisés comme nattes indépendantes de connexion entre circuits rigides, les circuits flexibles sont désormais le prolongement, à partir d'un même support, des couches de circuit imprimé des circuits rigides.

Pour fabriquer des circuits flex-rigides, il est connu de préparer le circuit final sur un support de type flexible et de venir ultérieurement coller à la main, par sérigraphie ou adhésif, des portions de support rigide sous les emplacements souhaités rigides du circuit préparé. Un tel procédé est couramment utilisé pour coupler des plaques de drain thermique sous des diodes de puissance d'un circuit flexible. Un autre exemple illustrant ce procédé est décrit dans le document FR-2871336. Néanmoins, ce procédé est laborieux, peu productif et peu reproductible, entraînant des coûts importants de fabrication.

Un premier but de l'invention est d'améliorer la productivité des procédés de fabrication de circuits imprimés semi-flexibles et donc d'améliorer le prix de revient unitaire de tels circuits.

Un autre but de l'invention est d'améliorer la reproductibilité du procédé de fabrication afin d'obtenir des circuits homogènes.

Un autre but de l'invention est d'automatiser le processus de fabrication, en réduisant fortement l'intervention manuelle de l'homme.

On connaît également, par le document FR-2871334, un procédé de fabrication de circuits imprimés semi-flexibles comprenant une étape de collage d'un substrat flexible sur un substrat rigide pour former un ensemble collé, ledit substrat rigide comprenant au moins deux ouvertures traversantes.

On entend par "traversante", toute ouverture pratiquée dans l'épaisseur d'un élément, notamment le substrat rigide ou l'ensemble collé. Il est notamment connu de l'homme du métier que les substrats utilisés dans le domaine des circuits imprimés se présentent sous la forme de couches (plaques ou feuilles) définissant des surfaces de circuit imprimé ; l'épaisseur représente la dimension perpendiculaire auxdites surfaces.

Plus précisément, le circuit imprimé constitué du substrat flexible doublé d'une piste cuivre est collé sur un drain thermique rigide en aluminium. Le drain thermique est muni d'ouvertures longitudinales traversantes. L'ensemble formé est ensuite découpé perpendiculairement aux ouvertures pratiquées dans le drain thermique afin de libérer des contraintes de rigidité. Les circuits imprimés obtenus sont du type semi-flexible avec une zone flexible correspondant aux parties de circuit imprimé initialement disposées au regard des ouvertures pratiquées dans le drain.

Il est à noter qu'un grand nombre d'étapes supplémentaires de gravure, vernissage de la piste cuivre est effectué alors que le substrat flexible et la piste cuivre sont déjà collés sur le drain thermique. Les ouvertures pratiquées dans le drain thermique ne peuvent être de largeur importante car le support flexible en regard de ces ouvertures peut s'affaisser lors de ces étapes supplémentaires. Lorsque le support flexible s'affaisse trop, la surface à graver/vernir n'est plus plane mais courbe. Il en résulte une qualité moindre du circuit imprimé voire des défauts rédhibitoires du circuit électrique gravé.

L'état de l'art comprend aussi le document EP-A-0126856.

Un autre but de l'invention est de proposer un procédé de fabrication permettant d'élargir les zones flexibles finales d'un circuit semi-flexible sans complexifier les étapes de formation des pistes gravées ni diminuer la qualité du circuit électrique.

Un autre but de l'invention est d'améliorer la qualité du circuit imprimé semi-flexible sur la zone flexible lorsque cette dernière est large.

Un autre but de l'invention est de fournir un appui pour une zone flexible de largeur importante lors des étapes supplémentaires de gravure/vernissage.

Au moins un de ces buts est atteint par la présente invention par l'application d'un collage sélectif visant à ne pas coller les substrats rigide et flexible entre eux sur une zone adjacente à l'ouverture pratiquée dans le substrat rigide afin de définir sensiblement la partie flexible du circuit flex-rigide résultant. Une autre zone adjacente à l'ouverture est généralement collée pour constituer la partie rigide du circuit flex-rigide résultant.

La zone non collée délimite la taille maximale de la zone flexible du circuit final flex-rigide et l'ouverture délimite la frontière entre la zone flexible finale et la zone rigide. Du fait de la présence du substrat rigide au-dessous de cette zone non collée, on conserve une zone d'appui pour procéder aux étapes de gravure/vernissage. La taille de la zone flexible peut ainsi être dimensionnée à souhait ; il suffit d'ajuster la zone non collée.

Du fait qu'aucun collage entre les deux substrats n'est prévu sur cette zone, il est aisé de libérer, après découpe, le substrat rigide afin de laisser apparaître la zone flexible dans son intégralité.

À cet effet, l'invention a tout d'abord pour objet un procédé de fabrication d'un circuit imprimé semi-flexible conformément à la revendication 1.

Tout procédé de collage sélectif connu de l'homme du métier est applicable à la présente invention, notamment par sérigraphie sélective.

Afin de libérer le substrat rigide sous la zone à vocation finale flexible, il est prévu une étape ultérieure de découpe dudit ensemble collé, ladite découpe étant effectuée en partie au niveau de ladite partie non collée de sorte à définir une cale du substrat rigide (non collé) à libérer. On entend par "cale du substrat rigide" la partie de substrat rigide non collée au substrat flexible, servant de support pour les étapes de gravure/vernissage et étant au final retirée pour laisser apparaître la zone flexible du circuit final. En particulier, le découpe passe par l'ouverture et se poursuit sur la zone non collée jusqu'à la même ouverture si l'on souhaite obtenir une partie flexible terminale du circuit flex-rigide (c'est-à-dire ne reliant pas une autre partie rigide), ou jusqu'à une autre ouverture dans une configuration où la partie flexible relie deux parties rigides du circuit flex-rigide.

Dans une configuration où l'on souhaite obtenir une partie flexible de circuit imprimé entre deux parties rigides, il est prévu que ledit substrat rigide comprend au moins deux ouvertures traversantes et ladite partie non collée est adjacente aux deux ouvertures, c'est-à-dire qu'elle s'étend au moins le long d'un chemin reliant lesdites au moins deux ouvertures dans la zone non collée. En appliquant par la suite, une découpe telle qu'exposée précédemment, on peut délimiter deux chemins reliant les deux ouvertures. L'ensemble des deux ouvertures et deux chemins définit les limites de la partie flexible reliant un premier circuit rigide au niveau de l'une des ouvertures et un deuxième circuit rigide au niveau de l'autre ouverture. La découpe le long de la zone non collée assure que la cale 24 de substrat rigide se détache.

La zone non collée et la découpe qui s'en suit peuvent notamment suivre tout chemin, droit ou courbe, reliant les deux ouvertures.

Pour obtenir des circuits plus complexes, il est prévu de multiplier le nombre de paires d'ouvertures entre lesquelles aucun collage n'est prévu pour délimiter des parties flexibles de circuit entre circuits rigides et le nombre d'ouvertures utilisées seules pour définir des parties flexibles terminales de circuit imprimé.

Il est également prévu, selon la complexité recherchée, que plusieurs parties flexibles s'étendent à partir d'une même ouverture. C'est-à-dire qu'une même ouverture peut être associées avec plusieurs autres ouvertures pour définir une pluralité de "ponts" flexibles entre circuits rigides et également être utilisée seule pour définir d'autres "languettes" flexibles terminales.

Enfin, une partie flexible de circuit imprimé peut relier plus de deux circuits rigides, par exemple quatre, auquel cas la zone non collée correspondante s'étend entre et est adjacente à quatre ouvertures, la découpe reliant chaque ouverture à deux autres des quatre ouvertures.

En pratique le substrat flexible comprend au moins sur sa face non collée une couche de matériau conducteur, type cuivre, sur laquelle est formée un circuit imprimé. La formation de ce dernier requiert la mise en place d'étapes supplémentaires, notamment la gravure et le vernissage.

L'invention a également pour objet le produit issu de ce procédé avant découpe, notamment une plaque pour la fabrication d'un circuit imprimé semi-flexible selon la revendication 15, comprenant un substrat flexible et un substrat rigide collés ensemble, ledit substrat rigide comprenant au moins une ouverture traversante, ledit collage entre les substrats étant sélectif de sorte qu'au moins une partie dudit substrat rigide adjacente à ladite ouverture n'est pas collée audit substrat flexible. De plus, lesdits substrats rigides et flexibles sont respectivement percés de trous pour le positionnement dudit circuit imprimé sur un support muni d'ergots, le diamètre d'un trou du substrat flexible étant inférieur au diamètre du trou correspondant du substrat rigide.

En particulier, ledit substrat rigide comprend au moins deux ouvertures traversantes et ladite partie non collée s'étend au moins le long d'un chemin reliant lesdites au moins deux ouvertures.

Notamment, la plaque comprend une pluralité de paires d'ouvertures traversantes et une pluralité de parties non collées correspondantes auxdites paires, chaque partie non collée étant adjacentes auxdites ouvertures correspondantes de chaque paire.

Après gravure et vernissage, par exemple, cette plaque est livrée pour le montage des composants électroniques. Il apparaît préférable d'effectuer cette étape sur une plaque rigide, c'est-à-dire avant découpe finale où les forces de rigidité sont relâchées et les parties flexibles libérées.

Dans cette optique, il est prévu que ladite étape de découpe comprend :
une première étape d'usinage dudit ensemble collé de sorte à former une zone de rupture le long d'au moins une partie d'un chemin de découpe, ledit chemin de découpe étant formé au moins en partie au niveau de la partie non collée ; cette étape pouvant être effectuée par le manufacturier du circuit imprimé ; et
une étape ultérieure de rupture dudit ensemble collé usiné le long du chemin de découpe de sorte à libérer ladite cale de substrat rigide ; cette étape pouvant être effectuée par le monteur de composants électroniques, une fois les composants montés.

On s'assure ainsi que la plaque reste rigide pour le montage, des zones de rupture assurant cette rigidité étant prévues pour être rompues sans difficultés par le monteur final.

On entend par "usinage" notamment le détourage par presse ou le fraisage par pilotage électronique. Ces opérations permettent de créer le chemin de découpe et de laisser certaines zones de ruptures en place pour conserver la rigidité de la plaque "pré-découpée".

Les zones de rupture peuvent consister en un fraisage de rainure en V sur une ou deux faces de la plaque, en une pluralité de trous traversants type "timbre poste". On prévoit au moins deux zones de rupture si celles-ci sont suffisamment larges, sinon au moins trois points d'accroche.

L'étape de rupture est généralement opérée par pliage de la plaque le long du chemin de découpe, les zones de rupture cédant sous l'effort exercé. À ce titre, les chemins de découpe sont préférentiellement linéaires.

En particulier, ledit usinage comprend la formation d'une succession d'ouvertures traversantes et de zones de rupture pratiquées sur ledit ensemble collé le long dudit chemin de découpe. Plus il y a d'ouvertures, moins l'effort de pliage pour rompre les zones de rupture est important.

Il est alors prévu que la plaque telle que présentée ci-dessus comprend un chemin de découpe au niveau de ladite au moins une partie non collée de sorte à définir une cale du substrat rigide à libérer, ledit chemin de découpe comprenant au moins une zone de rupture agencée pour être rompue de sorte à libérer ladite cale.

En alternative à la pré-découpe, il peut être prévu que ladite étape de découpe comprend la formation d'ouvertures traversantes tout le long d'un chemin de découpe, sans laisser de zone de rupture. Ces ouvertures passent préférentiellement au niveau de la ou des ouvertures déjà pratiquées dans le substrat rigide de sorte à former et libérer ladite cale.

Dans un mode de réalisation où ledit substrat rigide comprend au moins deux ouvertures traversantes, on peut prévoir que ledit chemin de découpe comprend au moins deux tracés s'étendant entre lesdites ouvertures, lesdits au moins deux tracés et deux ouvertures délimitant ladite cale de substrat rigide. Une réalisation simple comprend deux ouvertures allongées parallèles et les deux tracés sont perpendiculaires aux ouvertures de sorte à former une cale et une partie flexible de formes sensiblement rectangulaires.

Par ailleurs, il est prévu une étape de retrait de ladite cale de substrat rigide, une fois que la découpe est effectuée.

Le substrat flexible peut être choisi parmi une matière feux cuivre simple face, une matière flex cuivre double face. Eventuellement, un substrat multi-couches conductrices peut être utilisé pour autant qu'il présente des caractéristiques de flexibilité. A titre indicatif, un substrat FR4 d'épaisseur inférieure à 0,2 mm est considéré comme souple alors qu'avec une épaisseur supérieure à 0,8 mm, il est considéré comme rigide. Le cuivre peut être alternativement remplacé par tout métal conducteur. Notamment, ledit substrat flexible comprend sur sa face non collée (face externe) une couche conductrice, ledit procédé comprenant, en outre, une étape de gravure de ladite couche conductrice de sorte à former un circuit imprimé. Le coeur/support de la matière flexible est traditionnellement du type PEN (polyéthylène naftalate), PET (polyéthylène téréphthalate), polyimide ou FR4 mince (épaisseur inférieure ou égale à 0,2mm).

En particulier, ledit substrat flexible peut comprendre une couche conductrice sur chacune de ses faces. La couche conductrice sur la face collée (face interne) si non gravée permet d'accroître la dissipation thermique (ou le blindage vis-à-vis) d'un composant électronique intégré au circuit imprimé sur la face externe. Cette utilisation est généralement couplée avec un substrat rigide de type drain thermique (ou blindage). Éventuellement, la couche conductrice de la face interne peut, au préalable, être gravée, afin d'obtenir un circuit imprimé multi-couches.

Le substrat rigide peut être choisi parmi une plaque en matériau composite (CEM1, CEM3, FR4) simple ou doublée d'une couche (feuillard) de cuivre ou équivalent, un drain thermique ou de blindage notamment une plaque d'aluminium, cuivre ou laiton. Ainsi, il peut être prévu que ledit substrat rigide est un circuit imprimé simple face, ledit collage étant réalisé du côté opposé à la face imprimée.

L'utilisation d'une plaque composite simple permet d'obtenir un circuit flex-rigide simple face (éventuellement avec la couche intermédiaire si le substrat flexible est double face). L'utilisation d'une plaque doublée d'une couche cuivre sur la surface externe (celle non collée au substrat flexible) permet d'obtenir un circuit imprimé flex-rigide double face. Enfin, l'utilisation du drain permet d'obtenir un circuit flex-rigide SMI à dissipation thermique.

Lorsqu'un circuit imprimé flex-rigide double face ou multi-couches est obtenu, il est également prévu de réaliser un ou plusieurs vias conducteurs, type argent ou trou métallisé, entre les différentes couches de circuit imprimé de sorte à connecter électriquement lesdites couches. Le via argent est traversant dans l'épaisseur de l'ensemble collé.

Le collage peut être réalisé à partir de tout type de colle (par exemple époxy), de résine (époxy également) ou d'adhésif.

Dans un mode de réalisation, il est prévu, avant ladite étape de collage, une étape de formation d'un premier trou de registration traversant dans ledit substrat rigide, et, après ladite étape de collage, une étape de formation d'un deuxième trou de registration traversant dans ledit substrat flexible, ledit deuxième trou étant en regard du premier trou et le diamètre du deuxième trou étant inférieur au diamètre dudit premier trou. On obtient ainsi un trou global de registration qui améliore la tenue du circuit à un support par l'intermédiaire d'un ergot en prise avec le trou global de registration.

En particulier, la partie dudit substrat flexible restante en regard dudit premier trou est pourvu de découpes radiales améliorant la déformation, sans rupture, du substrat flexible lors de l'insertion de l'ergot.

La formation de trous de registration de diamètres différents entre le substrat flexible et le substrat rigide constitue un avantage supplémentaire aux autres caractéristiques du procédé de l'invention exposées ci-dessus et est indépendante de la nature semi-flexible du circuit obtenu. A ce titre, cette solution pourra être considérée indépendamment et faire l'objet d'une protection spécifique. Il en est de même du circuit obtenu par cette approche, circuit présentant un trou de registration traversant, le circuit comprenant un substrat rigide doublé d'un substrat flexible agencé pour porter une piste conductrice électriquement, le trou de registration étant formé par une première partie de trou pratiquée dans le substrat rigide et d'une deuxième partie de trou pratiquée dans le substrat flexible en regard de la première partie, le diamètre de la deuxième partie étant inférieur au diamètre de la première partie.

L'invention a également pour objet un circuit imprimé obtenu par le procédé ci-dessus incluant l'étape de découpage, le circuit comprenant une couche conductrice gravée sur la face dudit substrat flexible opposée audit substrat rigide.

L'invention a également pour objet un dispositif électronique comprenant un tel circuit imprimé et un support de circuit.

L'invention s'applique à tout système comprenant des circuits intégrés, en particulier aux équipementiers automobiles et aux feux de voitures lorsque les composants intégrés sont des diodes électroluminescentes.

L'invention dans sa configuration avec drain thermique s'applique particulièrement bien à l'éclairage extérieur pour lequel des diodes LED de puissance sont utilisées.

Le circuit imprimé selon l'invention utilisant un substrat flexible double face cuivre gravée s'applique particulièrement bien à la connectique entre circuits rigides pour diminuer la largeur de la partie flexible.

L'invention sera mieux comprise à l'aide de la description détaillée ci-dessous et des figures annexées dans lesquelles :
- la figure 1 représente un exemple en coupe de circuit intégré flex-rigide résultant du procédé selon la présente invention ;
- la figure 2 est un ordinogramme représentant une première réalisation de l'invention ;
- les figures 3 à 10 représentent des coupes de la structure élaborée aux différentes étapes du procédé de l'invention représenté en figure 2 ;
- les figures 4bis, 5bis et 10bis sont des vues du dessus des structures représentées respectivement aux figures 4, 5 et 10 ;
- les figures 11 à 13 représentent plusieurs réalisations de découpe selon l'invention en vue du dessus ;
- les figures 14 et 14bis représentent respectivement un circuit imprimé complexe obtenu selon le procédé de l'invention et la plaque gravée intermédiaire du procédé pour l'obtention du circuit de la figure 14, en vue du dessus ;
- la figure 15 est un ordinogramme représentant une autre réalisation de l'invention ;
- les figures 16 à 17 illustrent des moyens de pré-découpe mis en oeuvre dans la présente invention ;
- les figures 18 et 19 représentent un exemple en coupe de circuit imprimé double face obtenu par le procédé selon l'invention ; et
- les figures 20 à 22 illustrent des moyens de fixation d'un circuit imprimé sur un support.

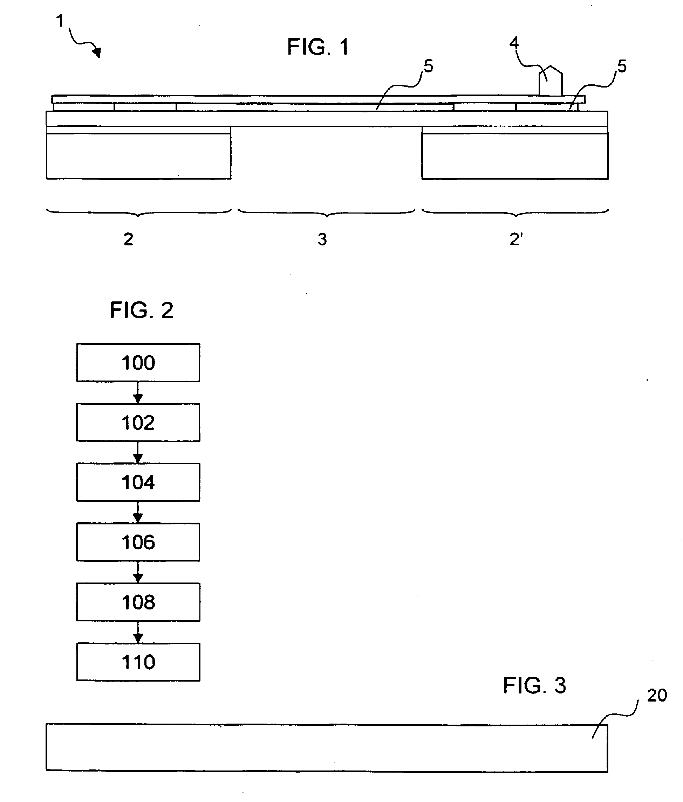

Un exemple de circuit imprimé flex-rigide 1 obtenu selon l'invention est illustré en figure 1. Ce circuit comprend deux parties rigides 2 et 2' et une zone flexible 3. Cela permet notamment de disposer les deux parties rigide de façon non-coplanaire (inclinaison de l'une à l'autre ou en escalier). À titre d'exemple, une diode 4 est montée sur le circuit imprimé en connexion électrique avec la piste gravée 5.

Le procédé de fabrication d'un tel circuit selon l'invention est décrit plus en détail en référence à la figure 2 et illustré par les figures 3 à 10bis.

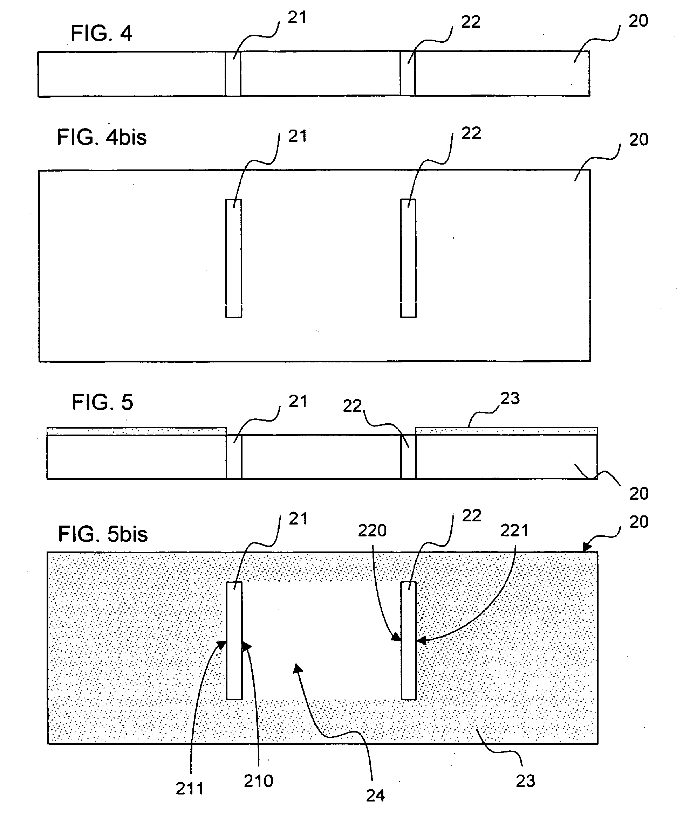

Partant d'un substrat rigide, type plaque d'aluminium 20 de quelques dixièmes de millimètres à plusieurs millimètres d'épaisseur, par exemple 1,6 mm, l'on pratique deux demi-fenêtres 21 et 22 traversantes dans l'épaisseur de la plaque 20 par détourage (100) (figure 4, vue en coupe de la plaque). Ces fenêtres sont allongées et parallèles dans l'exemple de la figure 4bis (vue du dessus de la plaque).

On applique (102) ensuite une colle époxy 23 (ou équivalent de type résine, adhésif) par sérigraphie sur la face supérieure de la plaque 20 de façon sélective (figure 5 - vue en coupe, figure 5bis - vue du dessus) : notamment la partie 24 située entre les deux fenêtres 21 et 22 n'est pas enduite de colle 23. En pratique, on s'assure qu'un côté de chaque fenêtre 21, 22 est enduit de colle 23 (côté qui correspondra à la partie rigide 2 du circuit 1) et l'autre côté n'est pas enduit de colle 23. Dans l'exemple des figures, l'on n'enduit pas le rectangle 24 de la plaque d'aluminium délimité par les deux fenêtres 21 et 22.

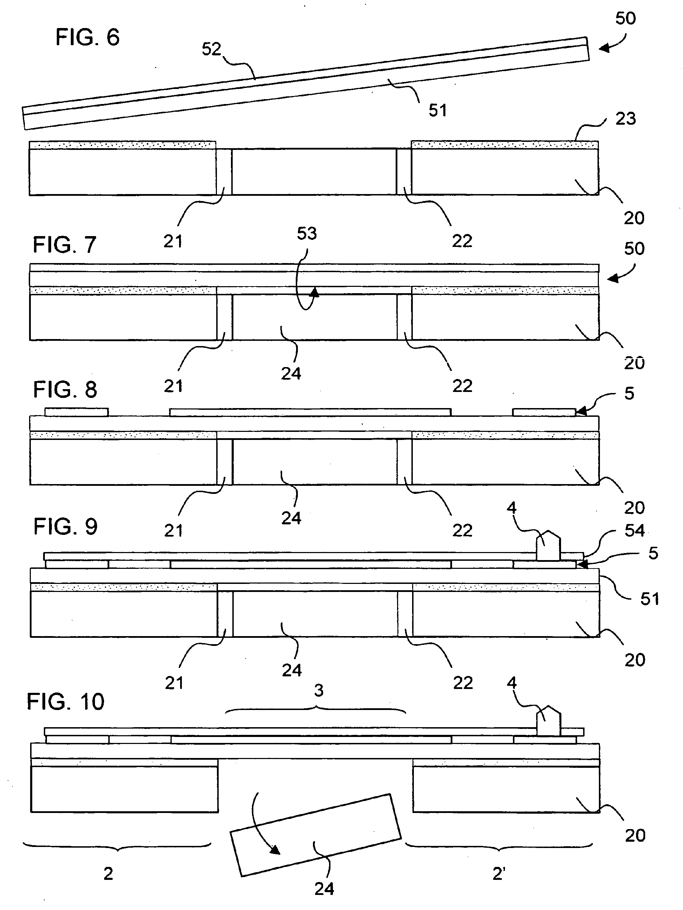

On dépose (104 et figure 6) ensuite une matière flexible cuivre simple face (flex SF) 50 constituée d'un support FR4 51 de quelques centaines de microns (µm) d'épaisseur, par exemple 100 µm, doublée d'un feuillard de cuivre 52 de quelques dizaines de microns, par exemple 18, 35, 70 ou 210 µm. Le flex SF 50 est posé sur la plaque 20 du côté du support FR4 51.

Ce dépôt peut être réalisé par laminage ou pressage ou simple contact du flex SF 50 (figure 7). On observe que la partie 53 du flex SF 50 n'est pas collée à la plaque d'aluminium 20. L'espace entre le flex 50 et la plaque 20 dans la zone non collée est faible de quelques µm (épaisseur de la colle). La colle 23 est ensuite polymérisée si nécessaire.

Des étapes ultérieures (106) de gravure du feuillard de cuivre 52 (figure 8) pour former les pistes électriques 5 du circuit imprimé 1, de dépôt d'un vernis 54 de protection et d'intégration de composants électroniques 4 (figure 9) sont effectuées. Ces étapes étant déjà connues de l'homme du métier, nous ne les décrivons pas plus en détail. Nous notons que la partie 24 de la plaque d'aluminium sert d'appui dans les opérations de gravure ou équivalentes effectuées sur la partie non collée 53 du flex SF 50.

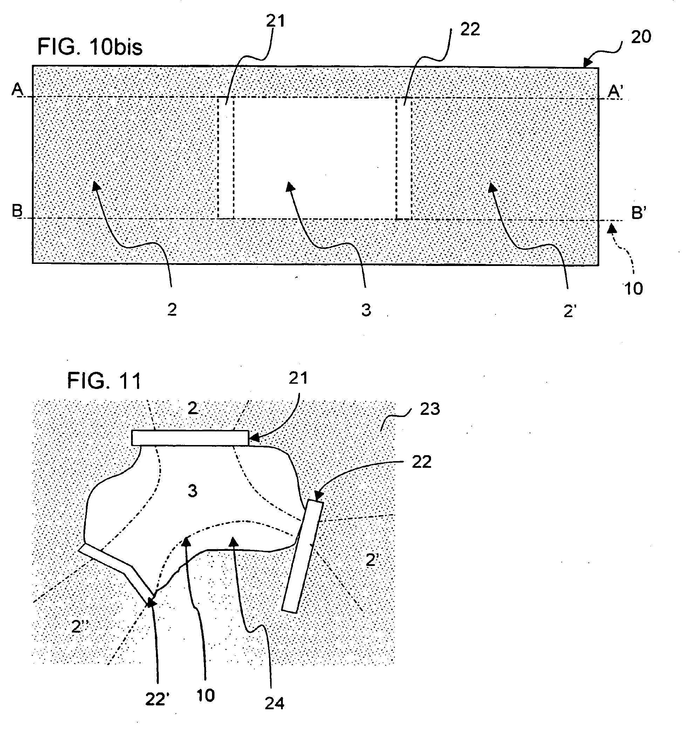

La structure ainsi constituée est découpée (108) selon les lignes discontinues A-A' et B-B' de la figure 10bis (pistes électriques gravées non représentées - vue du dessus). Cette découpe 10 est effectuée par détourage sous presse ou par fraisage. Un détourage de largeur 2 mm est largement répandu dans les techniques industrielles. Le chemin de découpe passe notamment par les fenêtres 21 et 22 et, entre les deux fenêtres, par la zone 24, 53 non collée. On obtient une partie centrale 24 de la plaque d'aluminium qui n'est plus solidaire du reste de la plaque, puisque le découpe et les fenêtres 21 et 23 forment un tracé fermé. En outre, puisque la découpe a eu lieu sur la partie non collée 53 du flexible 50, la partie centrale 24 se détache et peut être retirée (figure 10) de sorte à libérer (110) le circuit intégré résultant. On aboutit ainsi au circuit de la figure 1 avec une zone flexible centrale 3.

Tout forme de fenêtre 21, 22 peut convenir pour la mise en oeuvre de l'invention, notamment des fenêtres de formes différentes. La forme du bord 211, 221 de la fenêtre du côté où la colle est appliquée définit le contour de la frontière entre une partie rigide 2, 2' et la partie flexible 3 du circuit 1. Habituellement, on recherche une frontière linéaire et donc les fenêtres 21, 22 de type allongées telles que représentées dans l'exemple ci-dessus sont préférées.

Puisque la zone non collée correspond à la partie flexible 3 du circuit 1, on peut prévoir que la zone 24 où aucune colle 23 n'est appliquée peut prendre des formes variées. Pour former la zone flexible, il convient cependant que cette zone non collée 24 s'étende depuis un bord 210 de la fenêtre 21 vers un bord 220 de la fenêtre 22.

La figure 11 illustre un exemple de circuit flex-rigide 1 comprenant trois parties rigides 2, 2', 2" reliées par une unique portion flexible 3. La forme de la découpe 10 est quelconque à l'intérieur de la zone non collée 24, 53.

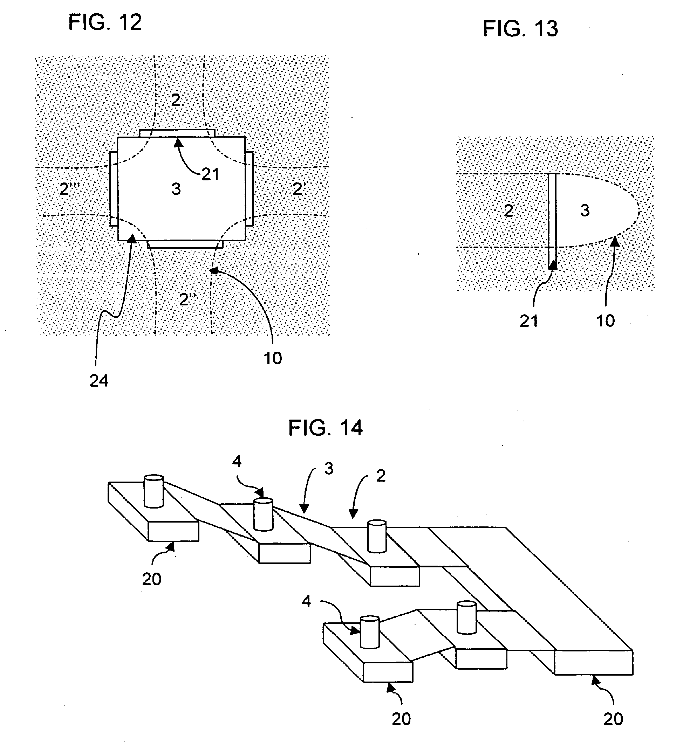

La figure 12 illustre un autre exemple dans lequel la zone flexible 3 relie quatre circuits rigides. La découpe entre les deux ouvertures est entièrement réalisée sur la zone non collée 24, 53.

La figure 13 représente une portion flexible 3 terminale de circuit imprimé 1. Pour être terminale, cette portion est réalisée à partir d'une seule fenêtre 21. La découpe 10 de la partie flexible est toujours effectuée sur la partie non collée 24, 53 de sorte qu'un contour fermé de découpe (découpe 10 + fenêtre 21) de la plaque 20 sur sa partie non collée 24 soit réalisé. La partie délimitée par ce contour est alors libérée laissant la portion flexible 3 libre.

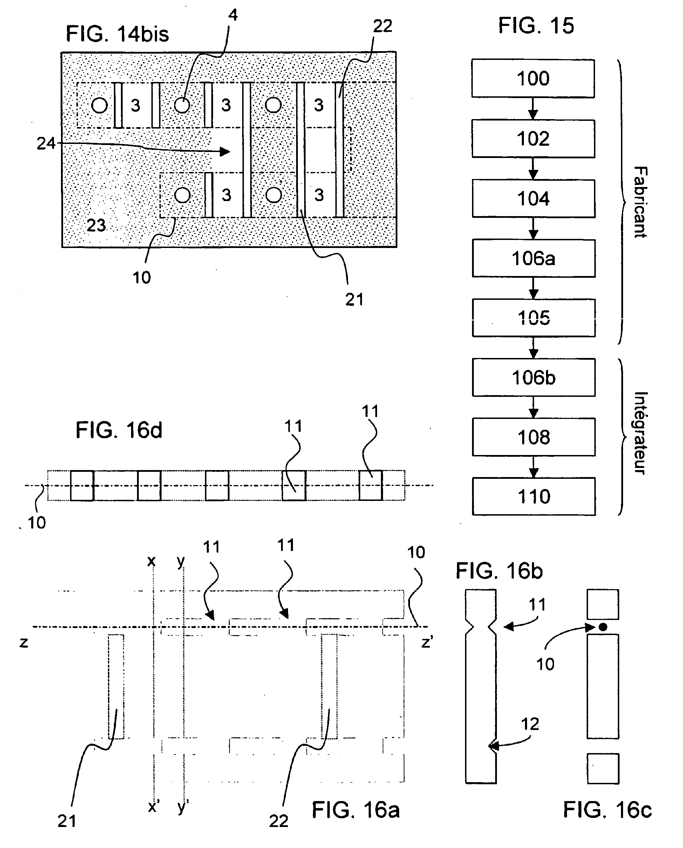

Ces différents exemples peuvent être combinés à souhait pour obtenir des circuits imprimés flex-rigides complexe 1. La figure 14 illustre l'obtention d'un circuit flex-rigide 1 composé de deux bandes de plusieurs LED 4 montées sur un drain de dissipation thermique en aluminium 20. La figure 14bis illustre la structure intermédiaire et les collages et fenêtres prévues selon l'invention. Une pluralité de paires d'ouvertures 21, 22 est prévue pour définir une pluralité de zones flexibles 3. Lors du dépôt du flex 50, aucune colle n'a été déposée sur les zones 3 correspondantes de la plaque 20. Puis une découpe selon le trait discontinu 10 permet de libérer chacune des cales de la plaque d'aluminium sous les zones 3.

Le procédé de l'invention décrit par la figure 15 s'inscrit dans les processus industriels traditionnels. On distingue d'une part le fabricant de circuit imprimé et l'intégrateur de composants électroniques.

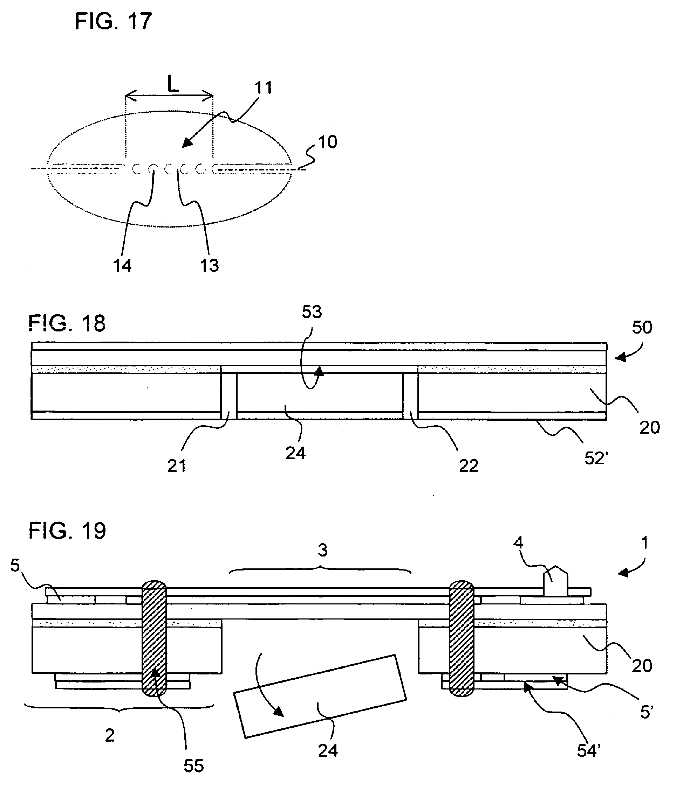

Partant de la plaque d'aluminium 20, le fabricant de circuit imprimé procède selon les étapes 100 (détourage initial), 102 (dépôt sélectif de colle 23) et 104 (application du substrat flexible 50) décrites précédemment en référence aux figures 2 à 7. Le processus côté fabricant est poursuivi par une étape de gravure 106a du feuillard de cuivre 52 pour obtenir un circuit imprimé selon le dessin souhaité par l'intégrateur (idem figure 8). Avant de livrer la plaque gravée de circuit imprimé gravée, le fabricant procède à une pré-découpe de cette plaque gravée comme décrit ci-après en référence aux figures 16 et 17.

La pré-découpe consiste à faciliter la découpe par l'intégrateur final de la plaque gravée encore rigide sans avoir recours à un outillage spécifique. Elle consiste en des zones 11 usinées agencées pour être rompu facilement, par exemple par pliage. Ces zones 11 sont disposées sur toute ou partie du chemin de découpe 10 final envisagé. Notamment, le chemin de découpe 10 au niveau de la partie non collée 24, 53 comprend certaines de ces zones 11.

La figure 16 montre un premier mode de réalisation dans lequel le fabricant de circuit imprimé détoure la plaque gravée le long du chemin de découpe 10 en laissant certaines zones pleines 11 (les différentes couches de la plaque gravée telle qu'illustrée par la figure 8 ne sont pas représentées ici). Comme illustré sur la figure 16a, ces zones 11 sont de faible dimension permettant de conserver la rigidité de la plaque gravée et d'être brisée sous la simple force de pliage des deux parties de plaque gravée de part et d'autre du chemin de découpe 10. Ces zones 11 ont une longueur de plusieurs millimètres, généralement supérieure à la largeur du détourage effectué le long du chemin 10. Plusieurs zones de maintien et rupture 11 sont disposées le long du chemin 10, notamment aux abords de la zone non collé 53, 24 de sorte à maintenir la pièce 24 sous le substrat rigide 53 pour la suite de l'intégration des composants.

Illustré par la figure 16b, ces zones 11 peuvent également être pré-usinées de sorte à prévoir une rainure 12 en V d'un côté de la plaque (bas de la figure 16b), de préférence du côté du substrat flexible, ou des deux côtés de la plaque (haut de la figure 16b). Cette rainure 12 facilite encore la rupture par l'intégrateur final. Les figures 16c et 16d montrent que le détourage 10 est traversant de sorte à séparer la plaque d'aluminium et que cinq zones de rupture 11 assurant la rigidité ont été conservées dans l'exemple du chemin de découpe de la figure 16a.

Une alternative à la pluralité de zones 11 consiste à prévoir la ou les rainures 12 tout le long du chemin de découpe, lequel est alors sensiblement linéaire.

En référence à la figure 17, les zones de rupture 11 peuvent être constituées d'une pluralité de perforations style "timbre poste" permettant une découpe manuelle facile. Les zones pleines 13 sont de petite dimension (nettement inférieure à la largeur du détourage) et les perforations 14 de taille sensiblement identique. La rigidité est obtenue par la succession des différentes zones pleines 13 sur une longueur L réduite (quelques millimètres). Il est également possible d'usiner ces zones 11 avec une ou deux rainures en V telles qu'illustrées par la figure 16b.

La gravure 106a peut être réalisée après l'étape de pré-découpe 105. Auquel cas, le maintien de la cale 24 au reste de la plaque 20 par l'intermédiaire des zones 11 facilite grandement la gravure de la zone flexible 53 puisque la cale 24 sert alors d'appui.

À l'issue de l'étape 105, la plaque gravée pré-découpée est toujours rigide grâce aux zones de maintien et rupture 11. Elle est livrée par le fabricant de circuit imprimé à l'intégrateur de circuit électronique.

Ce dernier procède alors à l'intégration des composants électroniques 4. Puisque la cale 24 n'est pas encore retirée et est maintenu rigide au reste de la plaque 20 par les zones 11, l'intégration de composants sur la zone 53 à terme flexible est facilitée.

L'étape de découpe finale 108 est alors réalisée simplement par l'intégrateur en rompant, par pliage, les zones de rupture 11. Aucun équipement de découpe n'est alors nécessaire pour l'intégrateur.

Cette découpe finale 108 permet le retrait de la cale 24 et la libération 110 du circuit flex-rigide 1.

Les figures 18 et 19 illustrent un circuit imprimé flex-rigide 1 obtenu selon l'invention pour lequel le substrat rigide 20 utilisé est doté d'une face cuivre 52' pour former une autre piste électrique 5' sur le verso du circuit 1.

L'étape de gravure 106, 106a est réalisée en même temps pour les deux feuillards 52 et 52' afin d'optimiser le processus de fabrication.

Des vias argents 55 sont réalisés dans l'épaisseur de la structure obtenue afin d'assurer une connexion entre les différentes pistes électriques 5, 5'.

Dans le processus d'intégration des circuits imprimés/intégrés 1 sur des supports de destination 200, il est courant d'assurer le positionnement de ces circuits par des trous de positionnement/registration 202 venant coopérer avec des ergots 201 prévus sur les supports 200.

Un problème actuel des solutions connues réside dans le fait que les parties de circuits rigides ont tendance à se détacher sous l'effet de vibrations ou de forces appliquées. Il y a donc un besoin d'améliorer la fixation des circuits, notamment des circuits flex-rigides 1, aux supports 200.

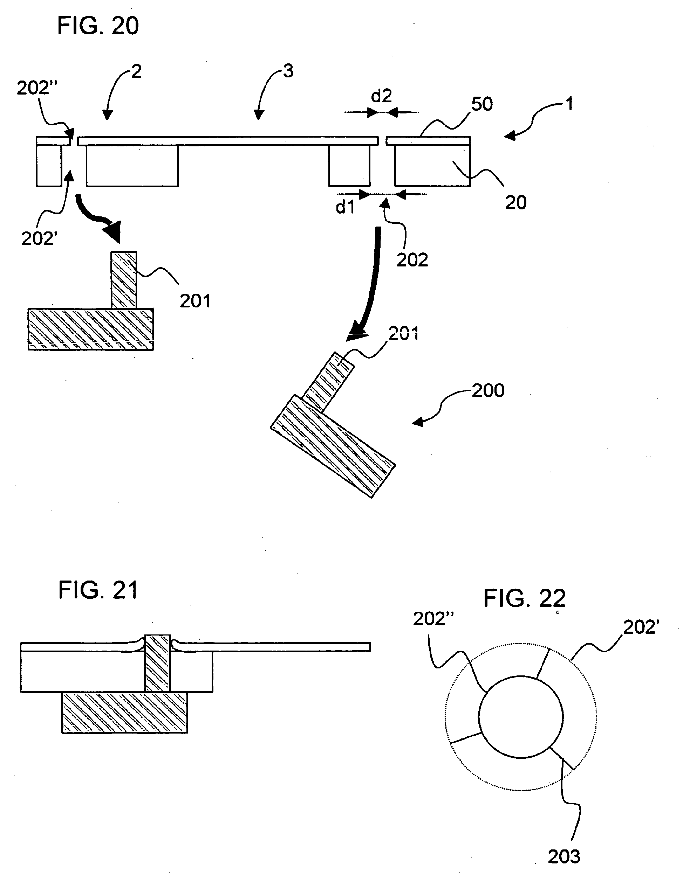

En référence aux figures 20, 21 et 22, ce problème est résolu dans l'invention par le fait que le substrat rigide est perforé avec un trou de registration 202' avant le dépôt du substrat flexible 50 et qu'une fois ce dernier déposé, le substrat flexible est également perforé selon le même axe que le trou de registration 202', le trou 202" pratiqué dans le substrat flexible ayant un diamètre inférieur à celui 202' pratiqué dans le substrat rigide. Ainsi, lorsque l'ergot 201 est introduit dans le trou 202 (formé par les deux parties 202' et 202") et le traverse, la partie du substrat flexible 50 obstruant en partie le trou 202' du substrat rigide 20 se déforme pour épouser l'ergot 201 et applique une force sur l'ergot 201 qui améliore le maintien.

La perforation par fraisage, presse ou perçage est prévu.

Les trous 202 et ergots 201 sont généralement cylindriques.

Le diamètre d2 du trou 202" pratiqué dans le substrat flexible 50 est compris entre 50 et 95 % du diamètre d1 du trou 202' pratiqué dans le substrat rigide 20, de préférence 75 à 90%, en particulier 80%.

Afin de favoriser la déformation et d'éviter la rupture du substrat flexible 50 lors de l'introduction de l'ergot 201, il est prévu des entailles 203 radiales sur la partie du substrat flexible 50 présente au niveau du trou de registration 202' du substrat rigide 20 (voir figure 22). En particulier, on prévoit au moins trois entailles 203, en particulier trois ou quatre réparties régulièrement sur l'anneau de substrat flexible délimité par les deux périmètres 202' et 202".

## Revendications

1. Procédé de fabrication d'un circuit imprimé semi-flexible (1) comprenant une étape de collage (104) d'un substrat flexible (50) sur un substrat rigide (20) pour former un ensemble collé, ledit substrat rigide comprenant au moins une ouverture traversante (21, 22, 22'), et une étape d'usinage dudit circuit, ladite étape de collage étant sélective (102) de sorte qu'au moins une partie (3, 24, 53) dudit substrat rigide (20) adjacente à ladite ouverture (21, 22, 22') n'est pas collée audit substrat flexible (50), **caractérisé en ce que** ladite étape d'usinage du circuit imprimé comprend perçage de trous (202, 202' ; 202") respectivement dans le substrat rigide (20) et dans le substrat flexible (50) pour le positionnement dudit circuit sur un support (200) muni d'ergots (201), le diamètre d'un trou (202") du substrat flexible (50) étant inférieur au diamètre du trou (202') correspondant du substrat rigide (20).

2. Procédé selon la revendication précédente, dans lequel ledit substrat rigide (20) comprend au moins deux ouvertures traversantes (21, 22, 22') et ladite partie non collée (3, 24, 53) est adjacente auxdites au moins deux ouvertures (21, 22, 22').

3. Procédé selon l'une des revendications précédentes, comprenant, en outre, une étape de découpe (108) dudit ensemble collé, ladite découpe étant effectuée en partie au niveau de ladite partie non collée (3, 24, 53) de sorte à définir une cale (24) du substrat rigide (20) à libérer (110).

4. Procédé selon la revendication précédente, dans lequel ladite étape de découpe (108) comprend :
une première étape d'usinage dudit ensemble collé de sorte à former une zone de rupture (11) le long d'au moins une partie d'un chemin de découpe (10) ;
une étape ultérieure de rupture (110) dudit ensemble collé usiné le long du chemin de découpe (10) de sorte à libérer (110) ladite cale (24) de substrat rigide (20).

5. Procédé selon la revendication précédente, dans lequel ledit usinage comprend la formation d'une succession d'ouvertures traversantes et de zones de rupture (11) pratiquées sur ledit ensemble collé le long dudit chemin de découpe (10).

6. Procédé selon la revendication 3, dans lequel ladite étape de découpe comprend la formation d'ouvertures traversantes le long d'un chemin de découpe (10).

7. Procédé selon l'une des revendications 4 à 6, dans lequel ledit substrat rigide (20) comprend au moins deux ouvertures traversantes (21, 22, 22') et ledit chemin de découpe (10) comprend au moins deux tracés s'étendant entre lesdites ouvertures (21, 22, 22'), lesdits au moins deux tracés et deux ouvertures délimitant ladite cale (24) de substrat rigide (20).

8. Procédé selon l'une quelconque des revendications précédentes, comprenant, en outre, une étape de retrait (110) de ladite cale (24) de substrat rigide (20).

9. Procédé selon l'une quelconque des revendications précédentes, dans lequel ledit substrat flexible (20) comprend sur sa face non collée une couche conductrice (52), ledit procédé comprenant, en outre, une étape de gravure (106) de ladite couche conductrice (52) de sorte à former un circuit imprimé (5).

10. Procédé selon l'une quelconque des revendications précédentes, dans lequel ledit substrat flexible (20) comprend une couche conductrice (52) sur chacune de ses faces.

11. Procédé selon l'une quelconque des revendications précédentes, dans lequel ledit substrat rigide (20) est un circuit imprimé simple face, ledit collage (104) étant réalisé du côté opposé à la face imprimée (5).

12. Procédé selon la revendication 1, dans lequel ledit substrat rigide (20) est perforé avant le dépôt du substrat flexible (50).

13. Procédé selon la revendication 1, dans lequel les trous (202) et ergots (201) sont généralement cylindriques.

14. Procédé selon la revendication 1, dans lequel ledit substrat rigide est percé d'au moins deux trous (202, 202') du même diamètre d1 que ceux des ergots du support, et ledit substrat flexible (50) est percé, selon les mêmes axes que les trous (202, 202') du substrat rigide, d'au moins deux trous (202") ayant un diamètre d2 inférieur à d 1.

15. Plaque pour la fabrication d'un circuit imprimé semi-flexible (1), comprenant un substrat flexible (50) et un substrat rigide (20) collés ensemble, ledit substrat rigide (50) comprenant au moins une ouverture traversante (21, 22, 22'), ledit collage entre les substrats (20, 50) étant sélectif de sorte qu'au moins une partie dudit substrat rigide (20) adjacente à ladite ouverture (21, 22, 22') n'est pas collée audit substrat flexible (50), **caractérisé en ce que** lesdits substrats rigides et flexibles sont respectivement percés de trous (202, 202' ; 202") pour le positionnement dudit circuit imprimé sur un support (200) muni d'ergots (201), le diamètre d'un trou (202") du substrat flexible (50) étant inférieur au diamètre du trou (202') correspondant du substrat rigide (20).

16. Plaque selon la revendication précédente, dans laquelle ledit substrat rigide (50) comprend au moins deux ouvertures traversantes (21, 22, 22') et ladite partie non collée (3, 24, 53) s'étend au moins le long d'un chemin reliant lesdites au moins deux ouvertures (21, 22, 22').

17. Plaque selon l'une des revendications 15 et 16, comprenant un chemin de découpe (10) au niveau de ladite au moins une partie non collée (3, 24, 53) de sorte à définir une cale (24) du substrat rigide (20) à libérer (110), ledit chemin de découpe (10) comprenant au moins une zone de rupture (11) agencée pour être rompue de sorte à libérer (110) ladite cale (24).

18. Plaque selon la revendication précédente, comprenant une pluralité de paires d'ouvertures traversantes (21, 22) et une pluralité de parties non collées correspondantes (3, 24, 53), chaque partie non collée (3, 24, 53) étant adjacentes auxdites ouvertures (21, 22) pour chaque paire.

19. Plaque selon la revendication 15, dans laquelle le diamètre (d2) des trous (202") du substrat flexible est compris entre 50 et 95 % du diamètre d1 des trous (202 , 202') pratiqué dans le substrat rigide (20), de préférence 75 à 90 %, en particulier 80%.

20. Plaque selon la revendication 15, dans laquelle le substrat flexible (50) est muni d'au moins trois entailles (203) au niveau du trou (202"), lesdites entailles étant réparties régulièrement sur l'anneau du substrat flexible délimité par les deux périmètres (202') et (202").

21. Circuit imprimé obtenu par le procédé selon l'une quelconque des revendications 3 ou 4 à 11 en dépendance de la revendication 3, le circuit comprenant une couche conductrice gravée (5) sur la face dudit substrat flexible (50) opposée audit substrat rigide (20).

22. Dispositif électronique comprenant un circuit imprimé (1) selon la revendication précédente et ledit support de circuit (200).

## Claims

1. Manufacturing method for a semi-flexible printed circuit (1) comprising a step (104) for bonding a flexible substrate (50) onto a rigid substrate (20) to form a bonded assembly, wherein said rigid substrate comprises at least one through opening (21, 22, 22'), and a step for machining said circuit, wherein said bonding step is selective (102) such that at least one part (3, 24, 53) of said rigid substrate (20) adjacent to said opening (21, 22, 22') is not bonded to said flexible substrate (50), **characterised in that** said step for machining the printed circuit comprises the drilling of holes (202, 202';202") respectively in the rigid substrate (20) and in the flexible substrate (50) for the positioning of said circuit on a support (200) equipped with tabs (201), wherein the diameter of a hole (202") of the flexible substrate (50) is smaller than the diameter of the corresponding hole (202') in the rigid substrate (20).

2. Method according to the previous claim, in which said rigid substrate (20) comprises at least two through openings (21, 22, 22') and said non-bonded part (3, 24, 53) is adjacent to said at least two openings (21, 22, 22').

3. Method according to any of previous claims, further comprising a step (108) for cutting out said bonded assembly, wherein said cut out is partially made on the non-bonded part (3, 24, 53) so that it defines a block (24) of the rigid substrate (20) to be freed (110).

4. Method according to the previous claim, in which said cutting out step (108) comprises:
- a first step of machining said bonded assembly so that a rupture zone (11) is formed along at least part of a cut-out path (10);
- a subsequent step of the rupture (110) of said bonded assembly machined along the cut-out path so that it frees (110) said block (24) of rigid substrate (20).

5. Method according to the previous claim, in which said machining comprises the formation of a succession of through openings and rupture zones (11) made on said bonded assembly along said cut-out path (10).

6. Method according to claim 3, in which said cutting-out step comprises the formation of through openings along said cut-out path (10).

7. Method according to any of claims 4 to 6, in which said rigid substrate (20) comprises at least two through openings (21, 22, 22') and said cut-out path (10) comprises at least two tracks extending between said openings (21, 22, 22'), wherein said at least two tracks and two openings define said block (24) of rigid substrate (20).

8. Method according to any of previous claims, further comprising a step for withdrawing said block (24) of rigid substrate (20).

9. Method according to any of previous claims, in which said flexible substrate (20) comprises on its non-bonded face a conductive layer (52), wherein said method further comprises a step for etching (106) said conductive layer (52) so as to form a printed circuit (5).

10. Method according to any of previous claims, in which said flexible substrate (20) comprises a conductive layer (52) on each of its faces.

11. Method according to any of previous claims, in which said rigid substrate (20) is a single sided printed circuit, wherein the bonding (104) is carried out on the face opposite the printed face (5).

12. Method according to claim 1, in which said rigid substrate (20) is perforated prior to the depositing of the flexible substrate (50).

13. Method according to claim 1, in which the holes (202) and the tabs (201) are generally cylindrical.

14. Method according to claim 1, in which said rigid substrate is pierced with at least two holes (202, 202') of the same diameter d1 as those of the tabs of the support, and said flexible substrate (50) is pierced, along the same axes as the holes (202, 202') of the rigid substrate, with at least two holes (202") with a diameter d2 smaller than d1.

15. Sheet for the fabrication of a semi-flexible printed circuit (1), comprising a flexible substrate (50) and a rigid substrate (20) bonded together, wherein said rigid substrate (50) comprises at least one through opening (21, 22, 22'), wherein said bonding between substrates (20, 50) is selective so that at least part of said rigid substrate (20) adjacent to said opening (21, 22, 22') is not bonded to said flexible substrate (50), **characterised in that** said rigid and flexible substrates are respectively pierced with holes (202, 202', 202") for the positioning of said printed circuit on a support (200) equipped with tabs (201), wherein the diameter of a hole (202") of the flexible substrate (50) is smaller than the diameter of the corresponding hole (202') of the rigid substrate (20).

16. Sheet according to the previous claim, in which said rigid substrate (50) comprises at least two, through openings (21, 22, 22') and said non-bonded part (3, 24, 53) extends at least along a path connecting said at least two openings (21, 22, 22').

17. Sheet according to any of claims 15 and 16, comprising a cut-out path (10) on said at least one non-bonded part (3, 24, 53) so as to define a block (24) of rigid substrate (20) to be freed (110), wherein said cut-out path (10) comprises at least one rupture zone (11) laid out so that it may be broken so as to free (110) said block (24).

18. Sheet according to the previous claim, comprising a plurality of pairs of through openings (21, 22) and a plurality of pairs of corresponding non-bonded parts (3, 24, 53), wherein each non-bonded part (3, 24, 53) is adjacent to said openings (21, 22) for each pair.

19. Sheet according to claim 15, in which the diameter (d2) of the holes (202") of the flexible substrate is between 50 and 95% of the diameter d1 of the holes (202, 202') made in the rigid substrate (20), preferably between 75 and 90%, especially 80%.

20. Sheet according to claim 15, in which the flexible substrate (50) has at least three notches (203) on the hole (202"), wherein said notches are evenly distributed on the ring of the flexible substrate defined by the two perimeters (202') and (202").

21. Printed circuit obtained by the method according to any of claims 3 or 4 to 11, dependent on claim 3, wherein the circuit comprises a conductive layer etched (5) on the face of said flexible substrate (50) opposite said rigid substrate (20).

22. Electronic device comprising a printed circuit (1) according to the previous claim and said circuit support (200).

## Patentansprüche

1. Verfahren zum Herstellen einer halbflexiblen gedruckten Schaltung (1), umfassend einen Schritt des Klebens (104) eines flexiblen Substrats (50) auf ein unflexibles Substrat (20), um eine geklebte Anordnung zu bilden, wobei das unflexible Substrat mindestens eine durchgehende Öffnung (21, 22, 22') umfasst, und einen Schritt des Bearbeitens der Schaltung, wobei der Schritt des Klebens selektiv (102) ist, so dass mindestens ein Teil (3, 24, 53) des unflexiblen Substrats (20) neben der Öffnung (21, 22, 22') nicht auf das flexible Substrat (50) geklebt wird, **dadurch gekennzeichnet, dass** der Schritt des Bearbeitens der gedruckten Schaltung das Bohren von Löchern (202, 202'; 202") jeweils in dem unflexiblen Substrat (20) und in dem flexiblen Substrat (50) für die Positionierung der Schaltung auf einer Unterlage (200), die mit Stiften (201) versehen ist, umfasst, wobei der Durchmesser eines Lochs (202") des flexiblen Substrats (50) kleiner als der Durchmesser des entsprechenden Lochs (202') des unflexiblen Substrats (20) ist.

2. Verfahren nach dem vorhergehenden Anspruch, wobei das unflexible Substrat (20) mindestens zwei durchgehende Öffnungen (21, 22, 22') umfasst und der nicht geklebte Teil (3, 24, 53) neben den mindestens zwei Öffnungen (21, 22, 22') liegt.

3. Verfahren nach der vorhergehenden Ansprüche, ferner umfassend einen Schritt des Ausschneidens (108) der geklebten Anordnung, wobei das Ausschneiden teilweise an dem nicht geklebten Teil (3, 24, 53) vorgenommen wird, um ein Füllstück (24) des freizugebenden (110) unflexiblen Substrats (20) zu definieren.

4. Verfahren nach dem vorhergehenden Anspruch, wobei der Schritt des Ausschneidens (108) Folgendes umfasst :
- einen ersten Schritt des Bearbeitens der geklebten Anordnung, um an mindestens einem Teil einer Schnittlinie (10) einen Bruchbereich (11) zu bilden;
- einen späteren Schritt des Abbrechens (110) der bearbeiteten geklebten Anordnung an der Schnittlinie (10) entlang, um das Füllstück (24) des unflexiblen Substrats (20) freizugeben.

5. Verfahren nach dem vorhergehenden Anspruch, wobei die Bearbeitung die Bildung einer Folge von durchgehenden Öffnungen und Bruchbereichen (11) umfasst, die auf der geklebten Anordnung an der Schnittlinie (10) entlang eingerichtet sind.

6. Verfahren nach Anspruch 3, wobei der Schritt des Ausschneidens die Bildung von durchgehenden Öffnungen an einer Schnittlinie (10) entlang umfasst.

7. Verfahren nach einem der Ansprüche 4 bis 6, wobei das unflexible Substrat (20) mindestens zwei durchgehende Öffnungen (21, 22, 22') umfasst und die Schnittlinie (10) mindestens zwei Spuren umfasst, die sich zwischen den Öffnungen (21, 22, 22') erstrecken, wobei die mindestens zwei Spuren und zwei Öffnungen das Füllstück (24) des unflexiblen Substrats (20) begrenzen.

8. Verfahren nach einem der vorhergehenden Ansprüche, ferner umfassend einen Schritt des Zurückziehens (110) des Füllstücks (24) des unflexiblen Substrats (20).

9. Verfahren nach einem der vorhergehenden Ansprüche, wobei das flexible Substrat (20) auf seiner nicht geklebten Seite eine leitfähige Schicht (52) umfasst, wobei das Verfahren ferner einen Schritt des Gravierens (106) der leitfähigen Schicht (52) umfasst, um eine gedruckte Schaltung (5) zu bilden.

10. Verfahren nach einem der vorhergehenden Ansprüche, wobei das flexible Substrat (20) eine leitfähige Schicht (52) auf jeder seiner Seiten umfasst.

11. Verfahren nach einem der vorhergehenden Ansprüche, wobei das unflexible Substrat (20) eine einseitige gedruckte Schaltung ist, wobei das Kleben (104) auf der der gedruckten Seite (5) gegenüberliegenden Seite erfolgt.

12. Verfahren nach Anspruch 1, wobei das unflexible Substrat (20) vor dem Abscheiden des flexiblen Substrats (50) gelocht wird.

13. Verfahren nach Anspruch 1, wobei die Löcher (202) und die Stifte (201) im Allgemeinen zylindrisch sind.

14. Verfahren nach Anspruch 1, wobei in dem unflexiblen Substrat mindestens zwei Löcher (202, 202') mit dem gleichen Durchmesser d1 gebohrt sind wie diejenigen der Stifte der Unterlage, und wobei in dem flexiblen Substrat (50) gemäß den gleichen Achsen wie die Löcher (202, 202') des unflexiblen Substrats mindestens zwei Löcher (202") gebohrt sind, die einen Durchmesser d2 aufweisen, der kleiner ist als d1.

15. Platte zur Herstellung einer halbflexiblen gedruckten Schaltung (1), umfassend ein flexibles Substrat (50) und ein unflexibles Substrat (20), die zusammengeklebt sind, wobei das unflexible Substrat (50) mindestens eine durchgehende Öffnung (21, 22, 22') umfasst, wobei das Kleben zwischen den Substraten (20, 50) selektiv ist, so dass mindestens ein Teil des unflexiblen Substrats (20) neben der Öffnung (21, 22, 22') nicht mit dem flexiblen Substrat (50) geklebt ist, **dadurch gekennzeichnet, dass** in den unflexiblen und flexiblen Substraten jeweils Löcher (202, 202'; 202") für die Positionierung der gedruckten Schaltung auf einer Unterlage (200) gebohrt sind, die mit Stiften (201) versehen ist, wobei der Durchmesser eines Lochs (202") des flexiblen Substrats (50) kleiner ist als der Durchmesser des entsprechenden Lochs des unflexiblen Substrats (20).

16. Platte nach dem vorhergehenden Anspruch, wobei das unflexible Substrat (50) mindestens zwei durchgehende Öffnungen (21, 22, 22') umfasst, und der nicht geklebte Teil (3, 24, 53) sich mindestens an einer Linie entlang erstreckt, welche die mindestens zwei Öffnungen (21, 22, 22") verbindet.

17. Platte nach einem der Ansprüche 15 und 16, umfassend eine Schnittlinie (10) an dem mindestens einen nicht geklebten Teil (3, 24, 53), um ein Füllstück (24) des freizugebenden (110) unflexiblen Substrats (20) zu definieren, wobei die Schnittlinie (10) mindestens einen Bruchbereich (11) umfasst, der angeordnet ist, um abgebrochen zu werden, um das Füllstück (24) freizugeben (110).

18. Platte nach dem vorhergehenden Anspruch, umfassend eine Vielzahl von Paaren von durchgehenden Öffnungen (21, 22) und eine Vielzahl von entsprechenden nicht geklebten Teilen (3, 24, 53), wobei jeder nicht geklebte Teil (3, 24, 53) neben den Öffnungen (21, 22) für jedes Paar liegt.

19. Platte nach Anspruch 15, wobei der Durchmesser (d2) der Löcher (202") des flexiblen Substrats zwischen 50 und 95% des Durchmessers d1 der Löcher (202, 202'), die in dem unflexiblen Substrat (20) eingerichtet sind, bevorzugt von 75 bis 90%, insbesondere bei 80% liegt.

20. Platte nach Anspruch 15, wobei das flexible Substrat (50) mit mindestens drei Einkerbungen (203) an dem Loch (202") versehen ist, wobei die Einkerbungen gleichmäßig auf dem Ring des flexiblen Substrats verteilt sind, der von den beiden Umfängen (202') und (202") begrenzt ist.

21. Gedruckte Schaltung, die durch das Verfahren nach einem der Ansprüche 3 oder 4 bis 11 in Abhängigkeit von Anspruch 3 erzielt wird, wobei die Schaltung eine gravierte leitfähige Schicht (5) auf der Seite des flexiblen Substrats (50) umfasst, die dem unflexiblen Substrat (20) gegenüberliegt.

22. Elektronische Vorrichtung, umfassend eine gedruckte Schaltung (1) nach dem vorhergehenden Anspruch und die Schaltungsunterlage (200).
